# EUROPEAN PATENT APPLICATION

(11) **EP 3 246 942 A1**
(43) Date of publication of application: **22.11.2017**
(21) Application number: 17169926.7
(22) Date of filing: 08.05.2017
(51) Int. Cl.: H01L 23/40, H01L 25/11, B62D 5/04, H02K 9/22, H02K 11/33, H05K 7/20, H01L 23/367

(54) **SEMICONDUCTOR DEVICE AND MOTOR APPARATUS**

(30) Priority: 18.05.2016 JP 2016099463
(71) Applicant: JTEKT CORPORATION, Osaka-shi, Osaka 542-8502 (JP)
(72) Inventor: SATO, Yuto, Osaka-shi, Osaka 542-8502 (JP)
(74) Representative: Winter, Brandl, Fürniss, Hübner, Röss, Kaiser, Polte - Partnerschaft mbB

(57) **Abstract**

A semiconductor device is provided that allows an IC chip and a heat sink to be prevented from being short-circuited even if facing surfaces of the IC chip and the heat sink are located closest to each other due to manufacturing variations and other variations. A controller for a motor apparatus includes a substrate (14) on which MOSFETs (15) are mounted and a heat sink (40) provided facing the substrate (14) and the MOSFETs (15) so as to dissipate heat generated by the MOSFETs (15). Insulating portions (15a) are each provided on a facing surface (15b) of each MOSFETs (15). Protruding portions (42) are each provided on a facing surface (40a) of the heat sink (40) so as to protrude from the heat sink (40) toward the insulating portion (15a) of the corresponding MOSFET (15). A second clearance (45) smaller than the first clearance is formed between each of the insulating portions (15a) and the corresponding protruding portion (42).

## Description

### BACKGROUND OF THE INVENTION

### 1. Field of the Invention

The invention relates to a semiconductor device and a motor apparatus integrally including the semiconductor device.

### 2. Description of the Related Art

Some known semiconductor devices used for a controller for a motor apparatus and the like include a substrate on which an IC chip is mounted and a heat sink provided on a surface on the opposite side of the substrate from the surface with the IC chip provided thereon. In such a semiconductor device, heat from the IC chip is transferred via the substrate to the heat sink, from which the heat is released to the outside air.

For semiconductor devices, there has been a demand to enhance heat dissipation without increasing the size of the semiconductor device. To meet the demand, a heat sink is also provided on the surface of the substrate with the IC chip provided thereon so as to release heat from the IC chip (see Japanese Patent Application Publication No. 2015-135852 (JP 2015-135852 A). This heat sink includes a contact portion that contacts the surface of the substrate with the IC chip provided thereon so as to cover the IC chip on the substrate. With the contact portion of the heat sink in contact with the substrate, a clearance is present between facing surfaces of the heat sink and the IC chip, and a heat dissipation material (heat dissipation grease or the like) is provided on the facing surfaces so as to fill the clearance.

In this case, the heat from the IC chip is transferred not only to the heat sink provided on the surface on the opposite side of the substrate from the surface with the IC chip provided thereon but also to the heat sink on the surface with the IC chip provided thereon, via the heat dissipation material. Therefore, the heat from the IC chip can be released through the opposite surfaces of the substrate, allowing the heat dissipation of the IC chip to be enhanced.

When heat is transferred from the IC chip to the heat sink via the heat dissipation material with which the clearance between the facing surfaces of the heat sink and the IC chip is filled, transfer efficiency increases as the clearance is decreased in size. Thus, in order to enhance the heat dissipation of the IC chip, the size of the clearance is preferably reduced as much as possible. The size of the clearance, that is, the distance between the facing surfaces of the IC chip and the heat sink, varies according to manufacturing variations among IC chips and heat sinks and a variation in the magnitude of thermal expansion of the heat sink.

The size of the clearance is set to a value at which the facing surfaces of the IC chip and the heat sink are expected to be prevented from contacting each other and being short-circuited even when the facing surfaces are located closest to each other due to the manufacturing variations and the variation in the magnitude of the thermal expansion. However, even with the variations taken into account, when the clearance is excessively reduced in size, the IC chip and the heat sink may be short-circuited if the facing surfaces of the IC chip and the heat sink are located closest to each other and the heat dissipation grease between the facing surfaces flows. Such a problem is generally common to semiconductor devices used for apparatuses other than the controller for the motor apparatus.

### SUMMARY OF THE INVENTION

An object of the invention is to provide a semiconductor device that allows an IC chip and a heat sink to be prevented from being short-circuited even if facing surfaces of the IC chip and the heat sink are located closest to each other due to manufacturing variations and other variations.

A semiconductor device in an aspect of the invention includes a substrate on which an IC chip is mounted and a heat sink provided facing the substrate and the IC chip on the substrate in so as to dissipate heat generated by the IC chip. An insulating portion insulated from the heat sink is provided on a surface of the IC chip, which faces the heat sink. A protruding portion is provided on a surface of the heat sink, which faces the IC chip, so as to protrude from the heat sink toward the insulating portion. Between the protruding portion and the insulating portion, a clearance is formed that is smaller than a clearance between the surface of the IC chip, which faces the heat sink, and a portion other than the protruding portion on the surface of the heat sink, which faces the IC chip.

In this configuration, the size of the clearance between the IC chip and the heat sink varies due to manufacturing variations among IC chips and heat sinks and a variation in the magnitude of thermal expansion of the heat sink. If facing surfaces of the IC chip and the heat sink are located closer to each other due to the variations, the protruding portion of the heat sink contacts the insulating portion provided on the IC chip to allow the IC chip and the heat sink to be restrained from being short-circuited.

In the semiconductor device in this aspect, a plurality of the IC chips may be mounted on the substrate, the insulating portion may be provided on each of at least two of the IC chips, and the protruding portion may include at least two protruding portions each protruding toward a corresponding one of the insulating portions of the at least two IC chips.

In this configuration, even if the facing surfaces of any of the IC chips and the heat sink are located closer to each other due to the above-described variations, possible short-circuiting of the at least two IC chips and the heat sink can be suppressed. This can enhance the suppression of short-circuiting in the case where a plurality of IC chips is mounted on the substrate.

In the semiconductor device in the above-described aspect, the insulating portion may be provided on each of all the IC chips, and the protruding portion includes the same number of protruding portions as that of the IC chips, the protruding portions each protruding toward a corresponding one of the insulating portions of the IC chips.

In this configuration, even if the facing surfaces of any of the IC chips and the heat sink are located closer to each other due to the above-described variations, the protruding portions provided so as to face the respective IC chips contact the insulating portions. This allows all of the IC chips to be restrained from being short-circuited with the heat sinks.

In the semiconductor device in the above-described aspect, on a surface on the opposite side of the substrate from the surface with the IC chip provided thereon, a heat sink may be provided that is different from the heat sink to which heat from the IC chip is transferred via the substrate.

In this configuration, the heat sink provided facing the substrate and the IC chip on the substrate so as to dissipate heat from the IC chip is intended to enhance heat dissipation of the IC chip while suppressing an increase in the size of the semiconductor device. This configuration can avoid short-circuiting between the heat sink and the IC chip.

A motor apparatus in another aspect of the invention includes the semiconductor device in the above-described aspect;
a motor that is driven to be controlled by the semiconductor device to rotate; and
a housing that houses the semiconductor device and the motor.

In this configuration, even if the facing surfaces of the IC chip and the heat sink are located closer to each other due to the above-described variations, the IC chip and the heat sink can be restrained from being short-circuited. Consequently, a motor apparatus can be constructed that is excellent in resisting the above-described variations. The motor apparatus allows drive control of the motor to be stabilized.

### BRIEF DESCRIPTION OF THE DRAWINGS

The foregoing and further features and advantages of the invention will become apparent from the following description of example embodiments with reference to the accompanying drawings, wherein like numerals are used to represent like elements and wherein:
FIG. 1 is an exploded perspective view schematically depicting a configuration of a motor apparatus in an embodiment of the invention;
FIG. 2 is a front view depicting a configuration of a heat sink in the motor apparatus;
FIG. 3 is a sectional view taken along line III-III in FIG. 1 and depicting a sectional structure of the motor apparatus, and is specifically an enlarged sectional view of an area R in FIG. 1; and
FIG. 4 is a diagram schematically depicting a configuration of a protruding portion of the heat sink.

### DETAILED DESCRIPTION OF EMBODIMENTS

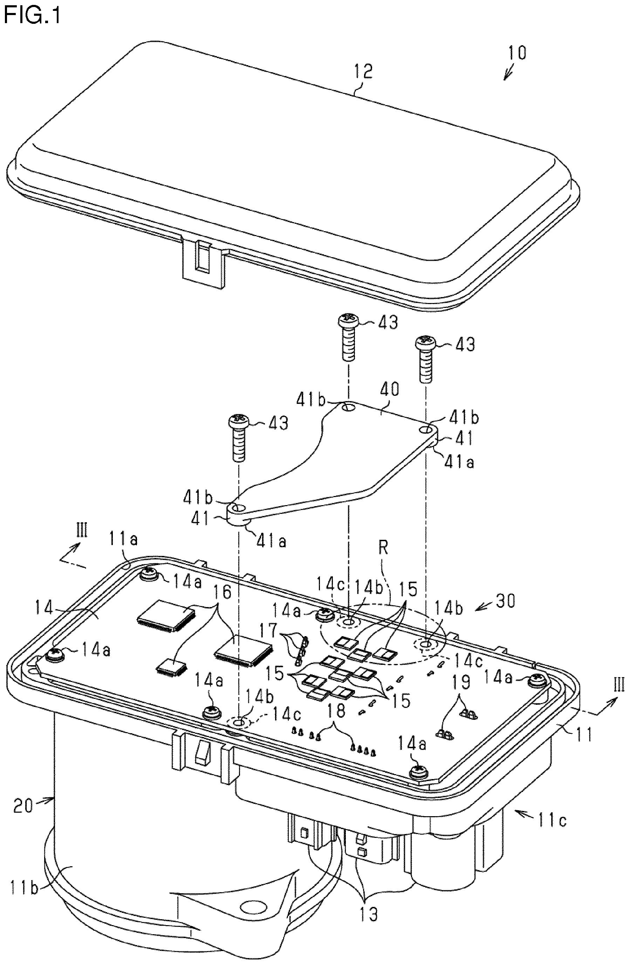

A semiconductor device and a motor apparatus according to an embodiment of the invention will be described. As depicted in FIG. 1, a motor apparatus 10 in the present embodiment is a unit of a motor with a drive control circuit in which a motor 20 including a motor shaft, a rotor, and a stator is integrated with a semiconductor device (hereinafter referred to as a controller) 30 including an inverter circuit that controllably drives rotation of the motor 20. The motor apparatus 10 in the present embodiment is mounted in, for example, an electric power steering system in a vehicle. The electric power steering system controls the motor apparatus 10 to assist a user's steering operation.

The motor apparatus 10 includes a housing 11 formed of a metal material such as aluminum and having a rectangular opening 11a. A cover 12 formed of a resin material such as a synthetic resin is attached to the opening 11a so as to occlude the opening 11a. The motor 20 and the controller 30 are housed inside the housing 11 and the cover 12 so as to form these components into a unit.

The housing 11 has a cylindrical motor housing portion 11b that houses the motor 20 and an attachment portion 11c to which a plurality of cylindrical connector portions 13 is attached that connects the controller 30 to an external apparatus (for example, a power supply or a control apparatus for a vehicle). The motor housing portion 11b extends, with respect to the housing 11, toward a side opposite from a side on which the cover 12 is attached to the housing 11. The attachment portion 11c is provided adjacent to the motor housing portion 11b in a longitudinal direction of the housing 11.

A substrate 14 shaped like a rectangle sized to extend over the motor housing portion 11b and the attachment portion 11c is fixed to the opening 11a of the housing 11 from the cover 12 side using fixing members 14a such as screws.

On the substrate 14, a plurality of (in the present embodiment, nine) field effect transistors (hereinafter referred to as MOSFETs) 15 is mounted as IC chips, and a plurality of (in the present embodiment, three) CPUs 16 is also mounted as IC chips to control operation of the MOSFETs 15. Besides the MOSFETs 15 and the CPUs 16, for example, a plurality of electronic components such as capacitors is mounted on the substrate 14. In the present embodiment, the substrate 14 and the MOSFETs 15, CPUs 16, and electronic components mounted on the substrate 14 form the controller 30.

The MOSFETs 15 are fixed to the substrate 14 in a particular area thereof where the MOSFETs 15 face the attachment portion 11c. The CPUs 16 are fixed to the substrate 14 in a particular area thereof where the CPUs face the motor housing portion 11b.

Motor bus bars 17 are arranged in an area of the substrate 14 between the set of MOSFETs 15 and the set of CPUs 16 to electrically connect the substrate 14 to the motor 20. In an area of the substrate 14 opposite from an area where the CPUs 16 are arranged with respect to the MOSFETs 15, connection terminals 18 electrically connecting the substrate 14 and the connector portions 13 together and power supply bus bars 19 are arranged. The MOSFETs 15, the CPUs 16, the motor bus bars 17, the connection terminals 18, the power supply bus bars 19, and the like are electrically connected together by wiring such as a copper plate provided on the substrate 14.

On a side of the substrate 14 where the MOSFETs 15 are provided (an upper side in FIG. 1), a heat sink 40 is provided that dissipates heat generated by the MOSFETs 15. The heat sink 40 is shaped like a plate formed of a metal material such as aluminum. The heat sink 40 is located between long sides of the substrate 14 so as to extend over the area where the MOSFETs 15 are provided. Consequently, the MOSFETs 15 are covered by the heat sink 40 from the cover 12 side so as to be protected.

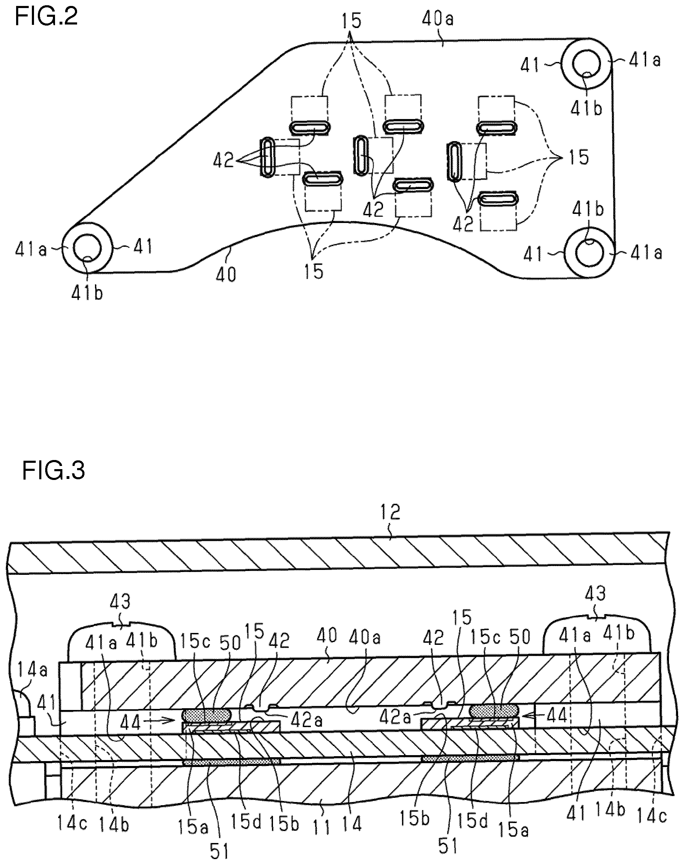

As depicted in FIG. 1 and FIG. 2, a plurality of (in the present embodiment, three) cylindrical pillar portions 41 is provided on a facing surface 40a of the heat sink 40 that faces the substrate 14, that is, the MOSFETs 15. The pillar portions 41 are provided on opposite sides of the heat sink 40 in a longitudinal direction thereof so as to extend from the facing surface 40a toward the MOSFETs 15. An axial end surface 41a of each of the pillar portions 41 is in abutting contact with the surface of the substrate 14 with the MOSFETs 15 provided thereon. The end surfaces 41a are in abutting contact with the surface of the substrate 14 in an area thereof where none of the wiring and the electronic components is provided such that the end surfaces 41a are insulated. Each of the pillar portions 41 is provided with a through-hole 41b penetrating the pillar portion 41 in an axial direction thereof.

As depicted particularly in FIG. 2, on the facing surface 40a of the heat sink 40, a plurality of (in the present embodiment, nine, which is the same number as that of the MOSFETs 15) protruding portions 42 is provided that protrudes in a direction in which the pillar portions 41 extend. With the end surfaces 41a of the pillar portions 41 of the heat sink 40 in abutting contact with the substrate 14, the protruding portions 42 are each located in association with the corresponding MOSFET 15 (long dashed double-short dashed lines in FIG. 2).

As seen back in FIG. 1, in each of the areas of the substrate 14 with which the respective pillar portions 41 are in abutting contact, a through-hole 14b is formed that communicates with the corresponding through-hole 41b of the pillar portion 41 and that passes through the substrate 14 in a thickness direction thereof. Heat release portions 14c are each provided radially outward of the corresponding one of the through-holes 14b. The heat release portions 14c are thermal vias that are holes for heat transfer, copper inlays that are copper pins buried in the substrate, or the like. At the surface on the opposite side of the substrate 14 from the surface with MOSFETs 15 provided thereon, the heat release portions 14c are in abutting contact with the housing 11.

The heat sink 40 is fixed to the opening 11a of the housing 11 from the cover 12 side along with the substrate 14 by inserting fixing members 43 such as screws through the respective pairs of the through-holes 41b, 14b. In this case, heat generated by the MOSFETs 15 and transferred to the heat sink 40 is transmitted to the housing 11 through the pillar portions 41 via the heat release portions 14c and then released from the housing 11 to the outside air.

Now, a configuration that allows dissipation of heat generated by the MOSFETs 15 will be described in detail. As depicted in FIG. 3, each of the MOSFETs 15 is entirely covered by an insulating portion 15a formed of a resin material such as a synthetic resin. Copper plates 15c are each provided on the facing surface 15b of the corresponding MOSFET 15 that faces the heat sink 40 such that the copper plate 15c is exposed for heat dissipation. The copper plates are provided away from the facing surface 40a of the heat sink 40. Heat dissipation grease 50 is provided in a first clearance 44 that is a clearance between the facing surface 40a of the heat sink 40 and the copper plate 15c provided on the facing surface 15b of each MOSFET 15 such that a part of the clearance is filled with the heat dissipation grease 50. In this case, the heat dissipation grease 50 insulates the heat sink 40 from each of the copper plates 15c and transfers heat between the heat sink 40 and the copper plate 15c. Consequently, heat generated by the MOSFETs 15 is transferred to the heat sink 40 through the copper plates 15c and the heat dissipation grease 50. The heat dissipation grease 50 is an example of a heat dissipation material.

Copper plates 15d are each provided on a surface of the corresponding MOSFET 15 that faces the substrate 14 such that the copper plate 15d is in abutting contact with the substrate 14 for heat dissipation. The surface on the opposite side of the substrate 14 from the surface with the MOSFETs 15 provided thereon is separated from the housing 11. Heat dissipation grease 51 is provided in a clearance between the housing 11 and the surface on the opposite side of the substrate 14 from the surface with the MOSFETs 15 provided thereon such that a part of the clearance at a position where each MOSFET 15 is located is filled with the heat dissipation grease 51. In this case, the heat dissipation grease 51 insulates the housing 11 from the substrate 14 and transfers heat between the housing 11 and the substrate 14. Consequently, heat generated by the MOSFETs 15 is transferred to the housing 11 through the copper plates 15d, the substrate 14 and the heat dissipation grease 51. Like the heat dissipation grease 50, the heat dissipation grease 51 is an example of a heat dissipation material.

In the present embodiment, the housing 11 is provided on the opposite side of the substrate 14 from the surface with the MOSFETs 15 provided thereon and is a heat sink different from the heat sink 40 that dissipates heat generated by the MOSFETs 15. The heat sink 40 is intended to achieve heat dissipation not only from the housing 11 but also from the cover side so that heat dissipation is enhanced without increasing the size of the controller 30.

Preferably, to enhance heat dissipation of the MOSFETs 15, the size of the first clearance 44 is preferably reduced as much as possible to increase transfer efficiency for heat transferred from the MOSFETs 15 to the heat sink 40 via the heat dissipation grease 50. The size of the first clearance 44, that is, the distance between the facing surfaces of each of the MOSFETs 15 and the heat sink 40, should be determined by a relative position between the MOSFET 15 and the heat sink 40 in the thickness direction of the substrate 14. However, in actuality, the relative position varies due to manufacturing variations related to the MOSFETs 15 and the heat sink 40 and a variation in the magnitude of thermal expansion of the heat sink 40.

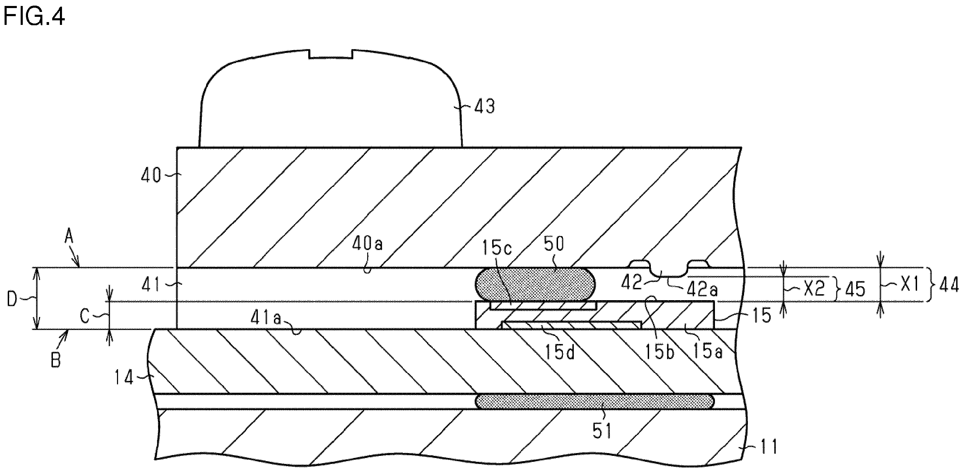

As schematically depicted in FIG. 4, in the present embodiment, the heat sink 40 is fixed to the substrate 14 via the pillar portions 41. Thus, manufacturing variations (A) to (D) may be taken into account.
(A) Manufacturing variation in the flatness of the facing surface 40a of the heat sink 40.
(B) Manufacturing variation in the flatness of the surface of the substrate 14 with the MOSFETs 15 provided thereon.
(C) Manufacturing variation in the height of the MOSFET 15 in the thickness direction of the substrate 14.
(D) Manufacturing variation in the height of the pillar portion 41 of the heat sink 40 in the thickness direction of the substrate 14.

The size of the first clearance 44 is set to a value at which the facing surface 15b of each MOSFET 15 and the facing surface 40a of the heat sink 40 are expected to be prevented from contacting each other even when the facing surfaces are located closest to each other due to the above-described variations. However, even with the variations taken into account, when the first clearance 44 is excessively reduced in size, each MOSFET 15 and the heat sink 40 may contact each other and be short-circuited if the facing surfaces of the MOSFET 15 and the heat sink 40 are located closest to each other and the heat dissipation grease 50 between the facing surfaces flows.

Now, a configuration that allows avoidance of disadvantageous contact between each MOSFET 15 and the heat sink 40 will be described. As schematically depicted in FIG. 4, each of the protruding portions 42 of the heat sink 40 is arranged so as to face the insulating portion 15a of the corresponding MOSFET 15. That is, each of the protruding portions 42 is provided so as to protrude from the facing surface 40a of the heat sink 40 toward the insulating portion 15a of the corresponding MOSFET 15.

A second clearance 45 smaller than the first clearance 44 is formed between a tip surface 42a of each protruding portion 42 and the facing surface 15b of the corresponding MOSFET 15. That is, the size of the second clearance 45 is set such that, when a length of the first clearance 44 in the thickness direction of the substrate 14 (vertical direction in FIG. 4) is denoted by X1 and a length of the second clearance 45 in the thickness direction of the substrate 14 is denoted by X2, a relationship X2 < X1 is satisfied. Considering the fact that the protruding portions 42 are provided, the first clearance 44 is a clearance between the the facing surface 15b of each MOSFET 15 and the entire area of the facing surface 40a of the heat sink 40 except for the protruding portions 42.

The above-described present embodiment produces the following effects. (1) The size of the first clearance 44 between each MOSFET 15 and the heat sink 40 varies due to manufacturing variations related to the MOSFETs 15 and the heat sink 40 and a variation in the magnitude of thermal expansion of the heat sink 40. When the facing surfaces 15b, 40a of each MOSFET 15 and the heat sink 40 are located closer to each other due to the above-described variations, each protruding portion 42 of the heat sink 40 contacts the insulating portion 15a of the corresponding MOSFET 15. This allows avoidance of short-circuiting between each MOSFET 15 and the heat sink 40.

(2) In the present embodiment, the insulating portion 15a is provided on the facing surface 15b of each MOSFET 15, and the protruding portions 42 are provided on the facing surface 40a of the heat sink 40. Compared to a case where protruding portions are provided on the facing surfaces 15b, 40a of the MOSFETs 15 and the heat sink 40 such that the protruding portions on the facing surfaces 15b are away from the protruding portions on the facing surface 40a, the present configuration allows more suitable avoidance of short-circuiting between the MOSFET 15 and the heat sink 40.

(3) Each MOSFET 15 is provided with the insulating portion 15a. The same number of protruding portions 42 as that of the MOSFETs 15 are provided so as to each protrude toward the insulating portion 15a of the corresponding MOSFET 15.

Consequently, even if any of the facing surfaces 15b of the MOSFETs 15 and the facing surface 40a of the heat sink 40 are located closer to each other due to the above-described variations, the protruding portion 42 provided so as to face the corresponding MOSFET 15 contact the insulating portion 15a. This avoids short-circuiting between the MOSFETs 15 and the heat sink 40.

(4) The heat sink 40 is intended to enhance heat dissipation of the MOSFETs 15 while suppressing an increase in the size of the controller 30, and can avoid short-circuiting with the MOSFETs 15.

(5) In the present embodiment, even if the facing surfaces 15b, 40a of each MOSFET 15 and the heat sink 40 are located closer to each other due to the above-described variations, short-circuiting between each MOSFET 15 and the heat sink 40 can be avoided. Consequently, a motor apparatus 10 can be constructed that tolerates the above-described variations. The motor apparatus 10 allows drive control of the motor 20 to be stabilized.

The above-described embodiment may be modified as needed and implemented in the following manners. The housing 11 need not function as a heat sink, and the heat sink 40 may exclusively dissipate heat generated by the MOSFETs 15. In this case, a part of the heat sink 40 may be exposed from the housing 11 or the cover 12 so that heat generated by the MOSFETs 15 can be released to the outside air through the exposed part.

In the above-described embodiment, clearance may be formed between the heat sink 40 and each of at least two MOSFETs 15 so that the MOSFET 15 and the heat sink 40 are not short-circuited if the facing surfaces 15b, 40a of each MOSFET 15 and the heat sink 40 are located closer to each other due to the above-described variations. That is, the number of the protruding portions 42 provided may be smaller than the number of the MOSFETs 15. For example, in the above-described embodiment, two to eight protruding portions 42 may be provided.

In the above-described embodiment, field effect transistors (MOSFETs) are illustrated as IC chips mounted on the substrate 14. However, other IC chips may be mounted. The heat dissipation grease 50, 51 is illustreated as a heat dissipation material. However, any material that allows heat to be dissipated may be used.

The controller 30 in the above-described embodiment is applicable to a straight type motor apparatus provided with the connector portions 13 extending in a direction in which the motor shaft of the motor 20 extends.

Described above as an example is the semiconductor device of the embodiment applied to the motor apparatus 10. However, the present invention is not limited to this. The semiconductor device in the above-described embodiment is applicable to any apparatus having a substrate on which IC chips are mounted, such as a motor apparatus in which less than nine IC chips are mounted or nine or more IC chips are mounted or a sensor in which only a single IC chip is mounted.

## Claims

1. A semiconductor device comprising:
a substrate on which an IC chip is mounted; and
a heat sink provided facing the substrate and the IC chip on the substrate so as to dissipate heat generated by the IC chip, wherein
an insulating portion insulated from the heat sink is provided on a surface of the IC chip, which faces the heat sink,
a protruding portion is provided on a surface of the heat sink, which faces the IC chip, so as to protrude from the heat sink toward the insulating portion, and
between the protruding portion and the insulating portion, a clearance is formed that is smaller than a clearance between the surface of the IC chip, which faces the heat sink, and a portion other than the protruding portion on the surface of the heat sink, which faces the IC chip.

2. The semiconductor device according to claim 1, wherein
a plurality of the IC chips are mounted on the substrate,
the insulating portion is provided on each of at least two of the IC chips, and
the protruding portion includes at least two protruding portions each protruding toward a corresponding one of the insulating portions of the at least two IC chips.

3. The semiconductor device according to claim 2, wherein
the insulating portion is provided on each of all the IC chips, and
the protruding portion includes the same number of protruding portions as that of the IC chips, the protruding portions each protruding toward a corresponding one of the insulating portions of the IC chips.

4. The semiconductor device according to any one of claims 1 to 3, wherein
to a surface on the opposite side of the substrate from the surface with the IC chip provided thereon, a heat sink is provided that is different from the heat sink to which heat from the IC chip is transferred via the substrate.

5. A motor apparatus comprising:
the semiconductor device according to any one of claims 1 to 4;
a motor that is driven to be controlled by the semiconductor device to rotate; and
a housing that houses the semiconductor device and the motor.
